# EUROPEAN PATENT SPECIFICATION

(11) **EP 4 009 525 B1**
(45) Date of publication and mention of the grant of the patent: **22.03.2023**
(21) Application number: 21211695.8
(22) Date of filing: 01.12.2021
(51) Int. Cl.: H03K 17/94, H03K 17/955

(54) **SENSOR BUTTON WITH GESTURE CONTROL**
SENSORTASTE MIT GESTENSTEUERUNG
BOUTON DE CAPTEUR AVEC COMMANDE DE GESTES

(30) Priority: 04.12.2020 EP 20211886
(43) Date of publication of application: 08.06.2022
(73) Proprietor: Captron Electronic GmbH, 82140 Olching (DE)
(72) Inventor: HÜTTENHOFER, Kilian, 81247 München (DE); AUBAUER, Roland, 82245 Wessling (DE); RÜTH, Felix, 82140 Olching (DE)
(74) Representative: Lohr, Jöstingmeier & Partner

(56) References cited:
- DE-A1-102014 008 430
- DE-A1-102015 212 129
- DE-A1-102018 219 549
- US-A1- 2015 248 796
- US-A1- 2020 007 127

## Description

### Field of the invention

The invention relates to sensor buttons for public transport systems.

### Description of the related art

A person who wants to ride a bus or a train approaches its door and touches a button at the door or comes in proximity of the door to open the door. A sensor button does not have any mechanic component which requires maintenance and may fail with time. Instead the sensor button senses a person or an object approaching to the immediate proximity of a sensing surface of the sensor button. Although it may be sufficient to bring a hand or a finger as close as 5 mm to the sensing surface to trigger a signal, people mostly touch the sensor surface. This may spread unwanted virus and germs from one passenger to another one. Making a sensor button more sensitive to detect objects from a larger distance will cause a large number of false signals, for example from people simply passing by.

A door for a public transport system is disclosed in DE 10 2015 212 129 A1. The door has a sensor button which may be operated from the inside and the outside of the door to request opening of the door.

US 2020/0007127 A1 discloses a capacitive sensor switch with a touch display.

### Summary of the invention

The problem to be solved by the invention is to provide a sensor button which recognizes a hand of a person in a safe distance without false signals and provides signaling means to make the passenger aware of the possibility of operating the sensor button from a greater distance.

Solutions of the problem are described in the independent claims. The dependent claims relate to further improvements of the invention.

A sensor button includes at least one capacitive sensor and at least one optical sensor. The capacitive sensor is based on a sensor electrode which may be in, at, or close to a surface of the sensor button. The capacitive sensor electrode is coupled to a sensor circuit for detecting the presence of an object in a first detection space, herein referenced a capacitive detection space. An object to be detected may be a hand, a finger, or another body part of a person. The capacitive detection space may be a space which may be defined by a base, having approximately the size of the sensor electrode and a height extending in a direction from the sensor electrode, the sensor button or an outer surface of the button. The height may be less than one of 10 cm, 5 cm, 2 cm, 1 cm. The capacitive detection space may extend in width with increasing distance from the sensor electrode. An object in this capacitive detection space has a certain capacitance to the capacitive sensor electrode, depending on the object's size and the distance. Through this capacitance, a capacitive current flows through the object and attenuates an AC signal at the capacitive sensor electrode. A larger capacitance results in a larger attenuation.

The at least one optical sensor is coupled to the sensor circuit to detect the presence of an object which may be a hand and/or a finger within an optical detection space which is further referred as optical detection space. The at least one optical sensor may be integrated into the surface or below of the button. It may be integrated or part of the sensor electrode. Furthermore, not only the presence but a gesture within the optical detection space may be detected. The detection may be based on reflection and/or absorption of light. If an object passes the optical sensor, external light may be attenuated (the sensor gets darker). In another embodiment, at least one light source like an LED may be provided to generate light which may be reflected by an object towards the optical sensor.

This light may be infrared, such that it is invisible to persons using the sensor. To achieve a spatial and/or directional resolution, the optical sensor may have multiple sensor elements. Such a sensor may include a camera and further may include a CCD or CMOS chip or a camera chip. It may also include a plurality of photodiodes. Such photodiodes may be mounted distant from each other or pointing into different directions, such that they distinguish different locations or directions of an object. Instead of or in addition to the optical sensor, a RADAR sensor may be provided.

The optical detection space may be distant from the sensor button. Therefore, it reaches out in some distance from the sensor button to detect object distant from the sensor button. The height of the optical detection space above the sensor button may be The height may be less than one of 10 cm, 5 cm, 2 cm, 1 cm. It may be more than 0,5cm or more than 10% or 20% of its height. This allows for persons to trigger the button without touching the button.

The button may further in addition have an extended optical detection space reaching down to the sensor or its surface. A detection of touching the surface by the extended space may result in a warning to a person touching the sensor surface.

In an embodiment, a spatial and/or directional resolution of the optical sensor may be obtained by providing a plurality of LEDs distant from the optical sensor. The LEDs may be activated such that only one or a subset of the LEDs is active or the light is encoded or modulated by a specific encoding or modulation scheme, such that an evaluation of the signal of the optical sensor indicates the LED from which light is received, further indicating the path of reflection and therefore the possible position and/or angle of an object.

The optical detection space may be more distant from the surface of the sensor button than the capacitive detection space. It may start at a distance from the surface of the sensor button of one of 10 cm, 5 cm, 2 cm, and may end at a distance of one of 50 cm, 30 cm, 20 cm, and 10 cm. The optical detection space may be selected such that a hand or a finger of a person within the optical detection space does not touch the surface of the sensor button. The optical detection space may at least partially overlap with the capacitive detection space, but it may at least be partially more distant from the sensor button than the capacitive detection space.

In an embodiment, the sensor circuit is configured to provide an output signal when a predetermined hand and/or finger gesture has been detected by the at least one optical sensor. In another embodiment, the output signal is generated when at the same time the at least one capacitive sensor electrode detects the presence of a hand and/or finger. This provides a very robust detection system, as two independent sensors have to detect the presence of a hand or a finger in addition to the optical sensor detecting a specific gesture. There is a comparatively low probability that a false indication is generated.

In another embodiment, the output signal is provided when the at least one optical sensor detects a gesture and the at least one capacitive sensor detects the presence of a hand and/or finger afterwards or before. This embodiment also provides a comparatively robust detection, as the signals of two independent sensors have to be provided in a sequence.

In an embodiment, the optical sensor may be mounted in a light channel or together with a lens for guiding and directing light. Such a light channel may block unwanted light, for example sunlight or other radiation interfering with the sensor. The channel may be part of a body which may be the sensor electrode or a holder of the sensor electrode. The lens may be integrated into the body.

In another embodiment, at least one LED is provided in a light channel as mentioned before.

In an embodiment, at least one LED may be arranged within a reflector and/or may have a lens or collimator. By a reflector, which may have an ellipsoid or parabolic shape, a lens or a collimator the light may be focused or bundled to obtain a better spatial resolution and or to extend the size of the optical detection space.

In a further embodiment, at least one visual indicator, e.g. a visible LED or a display is provided. Such a visual indicator may produce visible light which is visible to a person operating the button. It may provide a feedback, for example if a certain gesture or at least an approach of a body part to the switch has been identified. It may include a multi color LED. The visual indicator may have a static and/or dynamic mode or may be a dynamic display. A dynamic display may be provided by flashing or moving lights, e.g. a moving symbol. Flashing lights simply may attract attention, while moving lights may indicate a direction into which a person may move, e.g. the next open door. Further, an acoustic signal may be generated. A visual indicator may also be in a light channel and/or have a reflector and/or lens.

In an embodiment, the at least one visual indicator may include at least two LED which are configured to indicate a direction of movement of a hand. For example, if a hand approaches from the right side of the sensor button, a LED at the right side might light up, and if a hand approaches from the left side of the sensor button, a LED at the left side might light up.

In an embodiment, the visual indicator includes at least two multicolor LED which are configured to indicate a detection of an approach by a change of color. For example, if a hand approaching the sensor button or coming closer than a predetermined distance is detected, at least one LED may change color e.g. from green to red. Further a door may be opened.

In another embodiment, the at least one visual indicator includes at least two sets of LEDs having different colors, which are configured to indicate a detection of an approach by a change of color. Further, the at least two LED with different colors may be spaced apart, such that a change of color is coupled to a change of the location from which light is emitted.

A sensor button as mentioned herein may be mounted at a vehicle or at least one door of a vehicle or a public transport provides.

An embodiment relates to a vehicle or a public transport including a sensor button as mentioned herein.

### Description of Drawings

In the following the invention will be described by way of example, without limitation of the general inventive concept, on examples of embodiment with reference to the drawings.
Figure 1 shows a sensor button.
Figure 2 shows detection spaces.
Figure 3 shows a further embodiment of detection spaces.
Figure 4 shows a third embodiment of detection spaces.
Figure 5 shows a basic optical detection.
Figure 6 shows a block diagram of an embodiment.
Figure 7 shows a light channel.
Figure 8 shows a light reflector
Figure 9 shows a light reflector with a lens.
Figure 10 shows a bus with a sensor button.

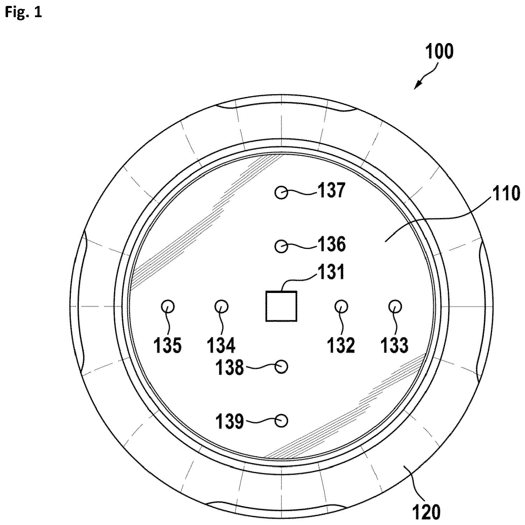

In Figure 1, a sensor button 100 which may be configured to be used in public transport system is shown. The sensor button 100 includes a sensor surface 110 which may be touched or approached by a person to generate a sensor signal. There may be a side wall for mounting the sensor button to a door, somewhere else in a public transport or to a surface in general.

The sensor surface 110 may include at least one capacitive sensor component like a conductive material like a metal plate or a metalized layer of a printed circuit board.

The sensor surface 110 may further include at least one optical sensor component. There may be at least one optical sensor 131. There may further be at least one light source, like an LED 132-139. The optical sensor 131 may include a camera which may be a single camera or a stereoscopic camera. Alternatively, or in addition, it may include at least one photodiode. It may include a plurality of photodiodes which may allow to sense a direction of light. The at least one light source 132-139 may be an infrared LED and/or a visible LED. An infrared LED may be used for presence detection, whereas a visual LED may be in addition used for optical signaling. There may be a combination of infrared LEDs for detection and of visible LEDs for user feedback and/or user guidance.

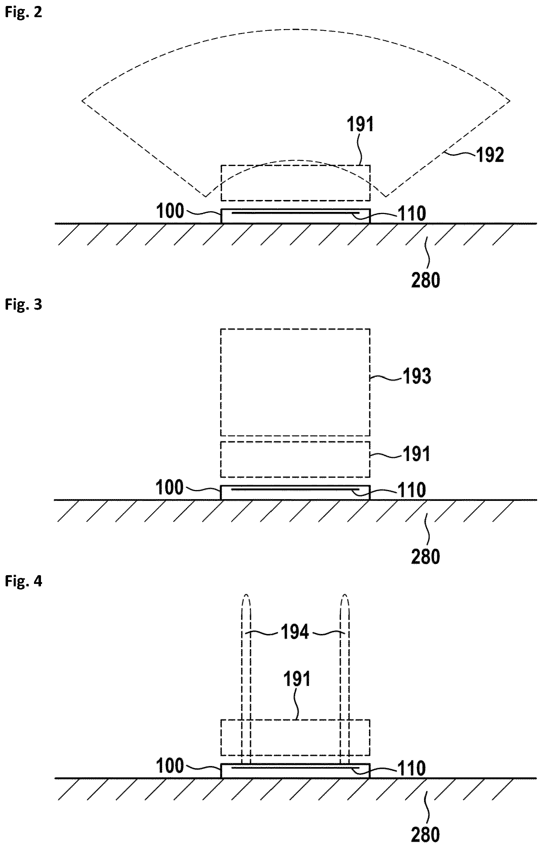

Figure 2 shows a first embodiment of detection spaces. In a schematic diagram, a side view of sensor button 100 is shown. The sensor button 100 is mounted to a mounting surface 280 which may be a part of a public transport, e.g. a door or a sidewall. The mounting surface may also be any suitable surface. It may be a part of a machine or a building, wherever the sensor button is used. On a side opposing to the mounting surface 280, which may be considered as being above the sensor switch, there is a capacitive detection space 191. Objects in this detection space may be detected by capacitive sensing means in the sensor button. This capacitive detection space may be comparatively close to a capacitive sensor surface 110, which may be a sensor electrode. It may even include the capacitive sensor surface 110. In an embodiment, the capacitive detection space 191 has a base area which is the same as the area of the sensor surface 110 and/or an area of the sensor button 105. It may have a height of less than at least one of 50 mm, 40 mm, 30 mm, 20 mm, 10 mm, 5 mm. Further, there may be an optical detection space 192 in which objects may be detected by optical detection means, like the optical sensor 131 together with LEDs 132-139. The optical detection space may have the same area as the close detection space, but also may extend beyond this area. It may have a height extending up to at least one of 50 cm, 40 cm, 20 cm, 10 cm, 5 cm above the sensor surface 110. It may approach the sensor surface as close as at least one of 10 cm, 5 cm, 2 cm, 1 cm. The optical detection space may be more distant to the sensor button than the capacitive sensor space. In an embodiment, the center of gravity of the optical detection space may be more distant to the sensor button than the center of gravity of the capacitive sensor space. In an embodiment, the detection spaces overlap at least slightly, but also they may be distant from each other. Instead or in addition to the optical sensor, a RADAR sensor may be used. As RADAR sensors work with quasi-optic propagating electromagnetic waves, they can cover similar detection ranges as optical sensors.

Figure 3 shows another embodiment of detection spaces. Here, the detection spaces, and specifically the alternate optical detection space 193, are smaller, such that they may not extent beyond the limits of the sensor button. This allows to use multiple sensor buttons close to each other, which further may communicate with each other, such extending the size of the detection spaces and providing a capability of detecting complex movement patterns. Further the detection spaces may not overlap. In another embodiment, the detection spaces may have a significant or full overlap which may allow for simultaneous detection of optical and capacitive signals e.g. to reduce false detections.

Figure 4 shows a third embodiment of detection spaces. Here two optical detection spaces 194 which have a narrow beam shape are shown. This allows detection of objects with a more precise spatial resolution and may result in a larger detection range. There may be any number of these detection space. There may also be any combination of the detection spaces mentioned herein.

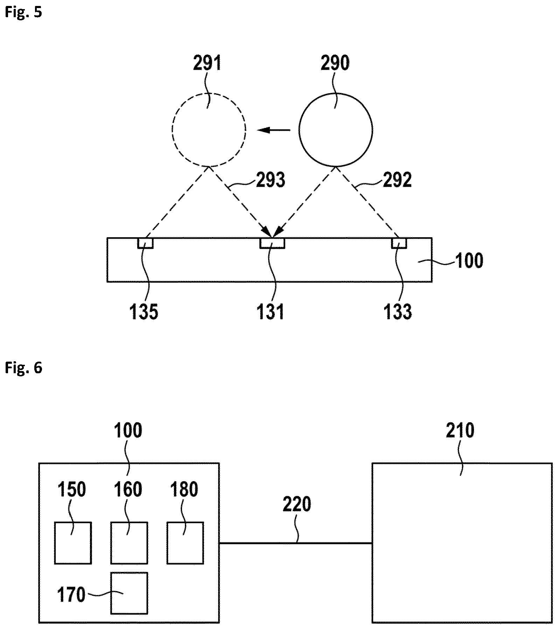

Figure 5 shows a basic optical detection. Here, a finger 290 is moved from a first position 290 to a second position 291. At position 290, there is a first light path 292 between a first LED 133 and an optical sensor 131. When the finger moves further to the second position 291, the first light path is interrupted, but a second light path 293 between a second LED 135 and the optical sensor 131 is established. By evaluating the light paths, the optical sensor 131 may indicate that some object has moved from the position of the first light path to a position of the second light path, and therefore in this example from the right side to the left side of the sensor. Other movements of an object may be detected by a similar way.

In an embodiment, the optical sensor 131 is configured to detect the angle of light received. This may for example be done by a camera chip or by multiple photo diodes. By evaluating the angle, a more detailed analysis of the track of movement of an object may be done.

In Figure 6, a block diagram of an embodiment is shown. The sensor button 100 includes a sensor electrode 150 which may be behind the sensor surface 110 or part of the sensor surface 110 as shown in Figure 1. The sensor button 100 further includes an optical sensor device 170 including an optical sensor and at least one light source like a LED.

The sensor button 100 also includes a sensor circuit 160 which may be connected to the sensor electrode to receive and evaluate signals from the sensor electrode to capacitively detect a presence of a person or a part of a person which may be close to the sensor surface. The sensor circuit may further be coupled to the optical sensor device 170 to receive and evaluate signals from the optical sensor to optically detect a presence of a person or a part of a person which may be distant from the sensor surface.

Further, a communication bus interface 180 may be provided to communicate by a communication bus 220 with a public transport vehicle controller 210. Communication with the public transport vehicle controller 210 may also be established wirelessly, e.g. by using the RF communication circuit.

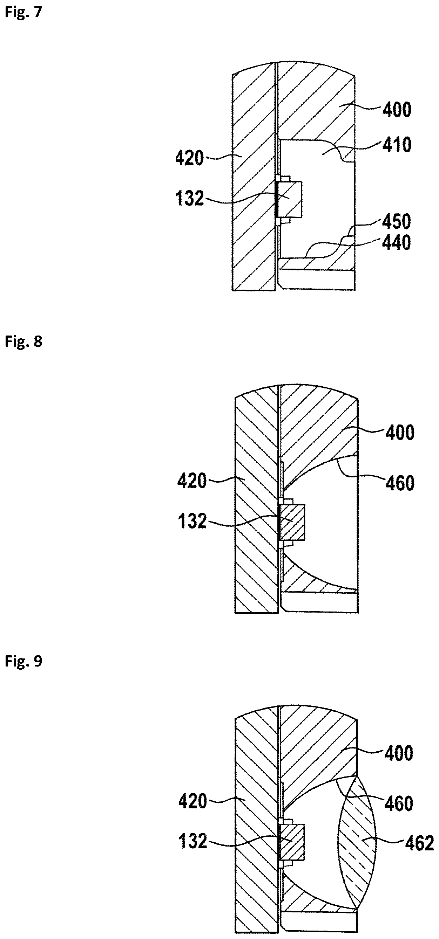

In figure 7, a light channel 410 is shown in detail in a side view. Such a light channel 410 may be used for at least one of the optical sensor, a photodiode, and a LED to direct light and to shield from unwanted light like sunlight. Here, a LED 132 is shown within a channel 410 formed by a body 400 on a printed circuit board 420. The body may be a metal body forming a sensor electrode. It may also be a dielectric body, when the sensor electrode is formed by the printed circuit board 420 or on a surface of the dielectric body. Each channel has at least one inner wall 440 which may have reflective properties. At the outer end (distant from the LED and the PCB) there is an opening 450 for entrance and/or exit of light.

In figure 8 a light reflector is shown. The reflector 460 may bundle the light from the LED and provide a narrower beam which may have a longer reach.

In figure 9, a reflector 460 with a lens 462 is shown. This results in better bundling and beam shaping. The lens may also be used without a reflector, or with a light channel.

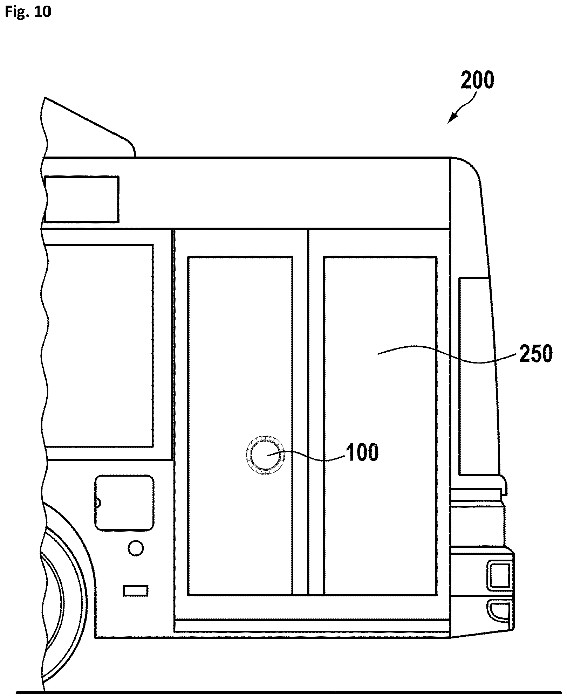

In Figure 10, a bus (public transport vehicle 200) is shown. It includes a door 250 which further has a sensor button 100.

### List of reference numerals

- 100: sensor button
- 110: capacitive sensor surface
- 112: antenna
- 120: sidewall
- 131: optical sensor
- 132 - 135: LED first axis
- 136 - 139: LED second axis
- 150: capacitive sensor electrode
- 160: sensor circuit
- 170: optical sensor device
- 180: communication bus interface
- 191: capacitive detection space
- 192: optical detection space
- 193: alternate optical detection spaces
- 194: beam shaped optical detection spaces
- 200: public transport vehicle
- 210: public transport vehicle controller
- 220: communication bus
- 250: public transport door
- 280: mounting surface
- 290: finger at first position
- 291: finger at second position
- 292: first light path
- 293: second light path
- 400: body
- 410: light channel
- 420: printed circuit board (PCB)
- 440: wall of light channel
- 450: opening of light channel
- 460: light reflector
- 462: lens

## Claims

1. A sensor button (100) including at least one capacitive sensor electrode (150) and at least one optical sensor (131) coupled to a sensor circuit (160), **characterized in, that**
the at least one capacitive sensor electrode (150) is coupled to the sensor circuit (160) for detecting the presence of a hand and/or a finger in a capacitive detection space (191), and
the at least one optical sensor (131) is coupled to the sensor circuit (160) for detecting the position of a hand and/or a finger within an optical detection space (192) and/or for detecting at least one hand and/or finger gesture within the optical detection space (192),
wherein the optical detection space (192) is at least partially more distant from the sensor button than the capacitive detection space (191) **characterized in, that**
the optical detection space (192) is distant from the sensor button.

2. A sensor button (100) according to claim 1,
wherein the optical detection space (192) at least partially overlaps with the capacitive detection space (191).

3. A sensor button (100) according to any of the previous claims,
wherein the sensor circuit is configured to provide an output signal when either a predetermined hand and/or finger gesture has been detected before by the at least one optical sensor (131) or
a predetermined hand and/or finger gesture is detected by the at least one optical sensor (131) and the at least one capacitive sensor electrode (150) detects the presence of a hand and/or a finger at the same time or a predetermined hand and/or finger gesture is detected by the at least one optical sensor (131) and the at least one capacitive sensor electrode (150) detects the presence of a hand and/or a finger afterwards or before.

4. A sensor button (100) according to any of the previous claims,
wherein the optical sensor (131) includes a camera chip and/or a plurality of photodiodes configured to detect light within the optical detection space.

5. A sensor button (100) according to any of the previous claims,
wherein at least one light channel (410) and/or lens (462) is provided for guiding light to the at least one optical sensor (131).

6. A sensor button (100) according to any of the previous claims,
wherein the sensor button (100) includes a plurality of LED (132 - 139) configured to emit light to be detected by the optical sensor (131).

7. A sensor button (100) according to claim 6
wherein at least one light channel (410) and/or reflector (460) and/or lens (462) is provided for guiding light from the at least one LED (132 - 139).

8. A sensor button (100) according to any of the previous claims,
wherein the sensor button (100) includes at least one visual indicator, which may be a LED and wherein
the visual indicator may be in a light channel (410) and/or may have a reflector (460) and/or may have a lens (462).

9. A sensor button (100) according to claim 8,
wherein the visual indicator is configured to provide a dynamic display and/or
the visual indicator includes at least two LED which are configured to indicate a direction of movement of a hand.

10. A sensor button (100) according to any of the claims 8 to 9,
wherein the visual indicator includes at least two multicolor LED which are configured to indicate a detection of an approach by a change of color.

11. A sensor button (100) according to any of the claims 8 to 10,
wherein the visual indicator includes at least two sets of LEDs having different colors, which are configured to indicate a detection of an approach by a change of color and
wherein at least two LED with different colors may be spaced apart, such that a change of color is coupled to a change of the location from which light is emitted.

12. A sensor button (100) according to any of the previous claims,
wherein the optical sensor (131) includes a RADAR sensor.

13. A sensor button (100) according to any of the previous claims,
wherein the sensor button (100) is configured for a public transport vehicle (200).

14. A public transport vehicle (200) including at least one sensor button (100) according to any of the previous claims,
**characterized in, that**
the at least one sensor button (100) is provided in, at or close to a door (250) of the public transport vehicle (200).

## Patentansprüche

1. Eine Sensortaste (100) beinhaltend mindestens eine kapazitive Sensorelektrode (150) und mindestens einen optischen Sensor (131), der mit einer Sensorschaltung (160) gekoppelt ist,
**dadurch gekennzeichnet, dass**
die mindestens eine kapazitive Sensorelektrode (150) mit der Sensorschaltung (160) gekoppelt ist, um das Vorhandensein einer Hand und/oder eines Fingers in einem kapazitiven Detektionsraum (191) zu detektieren, und der mindestens eine optische Sensor (131) mit der Sensorschaltung (160) gekoppelt ist, um die Position einer Hand und/oder eines Fingers innerhalb eines optischen Detektionsraums (192) und/oder mindestens eine Hand- und/oder Fingergeste innerhalb des optischen Detektionsraums (192) zu detektieren,
wobei der optische Detektionsraum (192) zumindest teilweise weiter von der Sensortaste entfernt ist als der kapazitive Detektionsraum (191), **dadurch gekennzeichnet, dass**
der optische Detektionsraum (192) von der Sensortaste beabstandet ist.

2. Eine Sensortaste (100) nach Anspruch 1,
wobei der optische Detektionsraum (192) zumindest teilweise mit dem kapazitiven Detektionsraum (191) überlappt.

3. Eine Sensortaste (100) nach einem der vorhergehenden Ansprüche,
wobei die Sensorschaltung so konfiguriert ist, dass sie ein Ausgabesignal bereitstellt, wenn entweder eine vorbestimmte Hand- und/oder Fingergeste zuvor von dem mindestens einen optischen Sensor (131) detektiert wurde, oder
eine vorbestimmte Hand- und/oder Fingergeste durch den mindestens einen optischen Sensor (131) detektiert wird und die mindestens eine kapazitive Sensorelektrode (150) gleichzeitig das Vorhandensein einer Hand und/oder eines Fingers detektiert, oder
eine vorbestimmte Hand- und/oder Fingergeste durch den mindestens einen optischen Sensor (131) detektiert wird und die mindestens eine kapazitive Sensorelektrode (150) das Vorhandensein einer Hand und/oder eines Fingers danach oder zuvor detektiert.

4. Eine Sensortaste (100) nach einem der vorhergehenden Ansprüche,
wobei der optische Sensor (131) einen Kamerachip und/oder mehrere Fotodioden beinhaltet, die konfiguriert sind, um Licht innerhalb des optischen Detektionsraums zu detektieren.

5. Eine Sensortaste (100) nach einem der vorhergehenden Ansprüche,
wobei mindestens ein Lichtkanal (410) und/oder mindestens eine Linse (462) vorgesehen ist, um Licht zu dem mindestens einen optischen Sensor (131) zu leiten.

6. Eine Sensortaste (100) nach einem der vorhergehenden Ansprüche,
wobei die Sensortaste (100) mehrere LEDs (132-139) beinhaltet, die so konfiguriert sind, dass sie Licht emittieren, das von dem optischen Sensor (131) detektiert werden soll.

7. Eine Sensortaste (100) nach Anspruch 6,
wobei mindestens ein Lichtkanal (410) und/oder mindestens ein Reflektor (460) und/oder mindestens eine Linse (462) vorgesehen ist, um Licht von der mindestens einen LED (132-139) zu leiten.

8. Eine Sensortaste (100) nach einem der vorhergehenden Ansprüche,
wobei die Sensortaste (100) mindestens eine visuelle Anzeige enthält, die eine LED sein kann, und wobei
die optische Anzeige in einem Lichtkanal (410) sein kann und/oder einen Reflektor (460) haben kann und/oder kann eine Linse (462) haben kann.

9. Eine Sensortaste (100) nach Anspruch 8,
wobei die visuelle Anzeige konfiguriert ist, um ein dynamisches Display bereitzustellen, und/oder die visuelle Anzeige mindestens zwei LEDs beinhaltet, die konfiguriert sind, um eine Bewegungsrichtung einer Hand anzuzeigen.

10. Eine Sensortaste (100) nach einem der Ansprüche 8 bis 9,
wobei die visuelle Anzeige mindestens zwei mehrfarbige LEDs beinhaltet, die konfiguriert sind, um eine Detektion einer Annäherung durch einen Farbwechsel anzuzeigen.

11. Eine Sensortaste (100) nach einem der Ansprüche 8 bis 10,
wobei die visuelle Anzeige mindestens zwei Sätze von LEDs mit unterschiedlichen Farben beinhaltet, die konfiguriert sind, um eine Detektion einer Annäherung durch einen Farbwechsel anzuzeigen, und
wobei mindestens zwei LEDs mit unterschiedlichen Farben voneinander beabstandet sein können, so dass ein Farbwechsel gekoppelt ist an einen Wechsel des Ortes, von dem Licht emittiert wird.

12. Eine Sensortaste (100) nach einem der vorhergehenden Ansprüche,
wobei der optische Sensor (131) einen RADAR-Sensor beinhaltet.

13. Eine Sensortaste (100) nach einem der vorhergehenden Ansprüche,
wobei die Sensortaste (100) für ein öffentliches Verkehrsmittel (200) konfiguriert ist.

14. Ein öffentliches Transportmittel (200) beinhaltend mindestens eine Sensortaste (100) nach einem der vorhergehenden Ansprüche,
**dadurch gekennzeichnet, dass**
die mindestens eine Sensortaste (100) in, an oder nahe einer Tür (250) des öffentlichen Transportmittels (200) vorgesehen ist.

## Revendications

1. Bouton de capteur (100) comportant au moins une électrode de capteur capacitif (150) et au moins un capteur optique (131) couplés à un circuit de capteur (160), **caractérisé en ce que**
l'au moins une électrode de capteur capacitif (150) est couplée au circuit de capteur (160) pour détecter la présence d'une main et/ou d'un doigt dans un espace de détection capacitive (191), et
l'au moins un capteur optique (131) est couplé au circuit de capteur (160) pour détecter la position d'une main et/ou d'un doigt au sein d'un espace de détection optique (192) et/ou pour détecter au moins un geste de main et/ou de doigt au sein de l'espace de détection optique (192),
dans lequel l'espace de détection optique (192) est au moins partiellement plus distant du bouton de capteur que l'espace de détection capacitive (191),
**caractérisé en ce que**
l'espace de détection optique (192) est distant du bouton du capteur.

2. Bouton de capteur (100) selon la revendication 1,
dans lequel l'espace de détection optique (192) chevauche au moins partiellement l'espace de détection capacitive (191).

3. Bouton de capteur (100) selon l'une quelconque des revendications précédentes,
dans lequel le circuit de capteur est configuré pour fournir un signal de sortie lorsque : un geste de main et/ou de doigt prédéterminé a été détecté avant par l'au moins un capteur optique (131), ou
un geste de main et/ou de doigt prédéterminé est détecté par l'au moins un capteur optique (131) et l'au moins une électrode de capteur capacitif (150) détecte la présence d'une main et/ou d'un doigt en même temps ou
un geste de main et/ou de doigt prédéterminé est détecté par l'au moins un capteur optique (131) et l'au moins une électrode de capteur capacitif (150) détecte la présence d'une main et/ou d'un doigt après ou avant.

4. Bouton de capteur (100) selon l'une quelconque des revendications précédentes,
dans lequel le capteur optique (131) comporte une puce de caméra et/ou une pluralité de photodiodes configurées pour détecter une lumière au sein de l'espace de détection optique.

5. Bouton de capteur (100) selon l'une quelconque des revendications précédentes,
dans lequel au moins un canal de lumière (410) et/ou une lentille (462) sont prévus pour guider une lumière vers l'au moins un capteur optique (131).

6. Bouton de capteur (100) selon l'une quelconque des revendications précédentes,
dans lequel le bouton de capteur (100) comporte une pluralité de DEL (132 à 139) configurées pour émettre une lumière à détecter par le capteur optique (131).

7. Bouton de capteur (100) selon la revendication 6
dans lequel au moins un canal de lumière (410) et/ou un réflecteur (460) et/ou une lentille (462) sont prévus pour guider une lumière depuis l'au moins une DEL (132 à 139) .

8. Bouton de capteur (100) selon l'une quelconque des revendications précédentes,
dans lequel le bouton de capteur (100) comporte au moins un indicateur visuel, qui peut être une DEL et dans lequel
l'indicateur visuel peut être dans un canal de lumière (410) et/ou peut avoir un réflecteur (460) et/ou peut avoir une lentille (462).

9. Bouton de capteur (100) selon la revendication 8,
dans lequel l'indicateur visuel est configuré pour fournir un affichage dynamique et/ou
l'indicateur visuel comporte au moins deux DEL qui sont configurées pour indiquer une direction de mouvement d'une main.

10. Bouton de capteur (100) selon l'une quelconque des revendications 8 et 9,
dans lequel l'indicateur visuel comporte au moins deux DEL multicolores qui sont configurées pour indiquer une détection d'une approche par un changement de couleur.

11. Bouton de capteur (100) selon l'une quelconque des revendications 8 à 10,
dans lequel l'indicateur visuel comporte au moins deux jeux de DEL ayant des couleurs différentes, qui sont configurés pour indiquer une détection d'une approche par un changement de couleur et
dans lequel au moins deux DEL de couleurs différentes peuvent être espacées, de sorte qu'un changement de couleur soit couplé à un changement de l'emplacement d'où une lumière est émise.

12. Bouton de capteur (100) selon l'une quelconque des revendications précédentes,
dans lequel le capteur optique (131) comporte un capteur RADAR.

13. Bouton de capteur (100) selon l'une quelconque des revendications précédentes,
dans lequel le bouton de capteur (100) est configuré pour un véhicule de transport en commun (200).

14. Véhicule de transport en commun (200) comportant au moins un bouton de capteur (100) selon l'une quelconque des revendications précédentes,
**caractérisé en ce que**
l'au moins un bouton de capteur (100) est prévu à l'intérieur, au niveau ou près d'une porte (250) du véhicule de transport en commun (200).
